# EUROPÄISCHE PATENTANMELDUNG

(11) **EP 1 113 276 A2**
(43) Veröffentlichungstag der Anmeldung: **04.07.2001**
(21) Anmeldenummer: 00126675.8
(22) Anmeldetag: 05.12.2000
(51) Int. Cl.: G01R 1/073

(54) **Verfahren und Vorrichtung zur Reinigung von Kontaktierungsnadeln**

(30) Priorität: 06.12.1999 DE 19958588
(71) Anmelder: ELMOS Semiconductor AG, 44227 Dortmund (DE)
(72) Erfinder: Binkhoff, Peter, 45711 Datteln (DE)
(74) Vertreter: Hilleringmann, Jochen, Dipl.-Ing.

(57) **Zusammenfassung**

Die Vorrichtung zum Entfernen von an den Enden von Kontaktierungsnadeln zum Kontaktieren der Bondpads eines Dies haftenden Bondpadmaterial-Ablagerungen ist mit einem Substrat mit einer adhäsiven Oberseite versehen, die von den Enden der Kontaktierungsnadeln kontaktierbar ist und die derart beschaffen ist, dass die Haftkraft zwischen den Ablagerungen und der Oberfläche des Substrats größer ist als die Haftkraft zwischen den Ablagerungen und den Enden der Kontaktierungsnadeln.

## Beschreibung

Die Erfindung betrifft ein Verfahren und eine Vorrichtung zum Entfernen von an den Enden von Kontaktierungsnadeln zum Kontaktieren der Bondpads eines Halbleiter-Die haftenden Bondpadmaterial-Ablagerungen. Ferner betrifft die Erfindung die Verwendung eines eine Haftkraft erzeugenden Oberseite aufweisenden Substrats zum Entfernen der Bondpadmaterial-Ablagerungen von den Enden der Kontaktierungsnadeln.

In verschiedenen Stadien der Herstellung von Halbleiter-Schaltkreisen ist es erforderlich, die Schaltkreise auf ihre elektrischen Funktionen hin zu testen. So werden beispielsweise die Dies auf der Siliziumscheibe elektrisch getestet, indem die Bondpads der Dies mit den Enden von Kontaktierungsnadeln berührt werden. Für einen guten elektrischen Kontakt bedarf es dabei einer gewissen Andrückkraft, mit der die Kontaktierungsnadeln auf den Bondpads der Dies aufliegen. Beim Wegbewegen der Kontaktierungsnadeln von den Bondpads nach dem Testvorgang bleiben Partikel des Bondpadmaterials, bei dem es sich im allgemeinen um AlSi- und/oder Al₂O₃-Partikel handelt, an den Enden der Kontaktierungsnadeln haften. Von Zeit zu Zeit ist es erforderlich, das sich auf diese Weise ansammelnde Bondpadmaterial von den Enden der Kontaktierungsnadeln zu entfernen, da ansonsten diese Ablagerungen zu die elektrische Funktion der Bondpads irreversibel beeinträchtigenden Beschädigungen führen können. Bisher wird bei diesem Reinigungsvorgang derart verfahren, dass die Kontaktierungsnadelenden über eine raue Oberfläche, beispielsweise Schleifpapier, bewegt werden, wodurch es zu einer Entfernung durch Abrasion kommt. Hierbei werden jedoch auch immer die Enden der Kontaktierungsnadeln beschädigt, weshalb die Lebensdauer dieser Kontaktierungsnadeln begrenzt ist. Durch die abrasive Entfernung der Bondpadmaterial-Ablagerungen werden die Enden der Kontaktierungsnadeln durch das abrasive Material aufgeraut, was ebenfalls zu Beschädigungen der Bondpads bei anschließender Kontaktierung derselben führen kann.

Aus JP-A-10339766 ist es bekannt, mit den Spitzen der Kontaktierungsnadeln zwecks Reinigung derselben von Zeit zu Zeit in ein Gummimaterial einzustechen. Dabei werden die an den Spitzen der Kontaktierungsnadeln haftenden Partikel in das Gummimaterial eingedrückt und verhaken sich in diesem, so dass sie im Gummimaterial zurückgehalten werden, wenn die Kontaktierungsnadeln anschließend wieder aus dem Gummimaterial herausgezogen werden. Dieser Reinigungsvorgang erfolgt also auf rein mechanische Weise, und zwar recht schonend für die Kontaktierungsnadelspitzen. Allerdings besteht die Gefahr, dass infolge des Einstechens der Kontaktierungsnadeln in das Gummimaterial Partikel von diesem an den Spitzen haften bleiben können, was die Funktionsweise der Kontaktierungsnadeln negativ beeinträchtigt.

Der Erfindung liegt die Aufgabe zugrunde, eine Vorrichtung, ein Verfahren und eine Verwendung eines Substrats zum Entfernen der Bondpad-Ablagerungen an den Enden von Kontaktierungsnadeln anzugeben, mit denen die Lebensdauer der Kontaktierungsnadeln erhöht, und die Gefahr von Beschädigungen beim anschließenden Kontaktieren der Bondpads reduziert sind, ohne dass die elektrischen Eigenschaften der Kontaktierungsnadeln beeinträchtigt sind.

Zur Lösung dieser Aufgabe wird mit der Erfindung eine Vorrichtung vorgeschlagen, die versehen ist mit
- einem Substrat mit einer adhäsiven Oberseite, die von den Enden der Kontaktierungsnadeln kontaktierbar ist und die derart beschaffen ist, dass die Haftkraft zwischen den Ablagerungen und der Oberfläche des Substrats größer ist als die Haftkraft zwischen den Ablagerungen und den Enden der Kontaktierungsnadeln.

Ferner wird mit der Erfindung ein Verfahren vorgeschlagen, bei dem
- die die Ablagerungen aufweisenden Enden der Kontaktierungsnadeln in Kontakt mit der eine Haftkraft auf die Ablagerungen ausübenden Oberseite eines Substrats gebracht werden, deren Haftkraft größer ist als die Haftkraft zwischen den Ablagerungen und den Enden der Kontaktierungsnadeln.

Schließlich wird mit der Erfindung auch die Verwendung eines eine Haftkraft erzeugenden Oberseite aufweisenden Substrats zum Entfernen von mit einer Haftkraft an den Enden von Kontaktierungsnadeln zum Kontaktieren der Bondpads von Halbleiterdies haftenden Ablagerungen durch Berührung der Oberseite des Substrats mit den Enden der Kontaktierungsnadeln vorgeschlagen.

In den Unteransprüchen sind weitere Ausgestaltungen der erfindungsgemäßen Vorrichtung, des erfindungsgemäßen Verfahrens und der erfindungsgemäßen Verwendung angegeben.

Nach der Erfindung ist sinngemäß vorgesehen, die Ablagerungen an den Kontaktierungsnadelenden dadurch zu entfernen, dass diese Enden in Kontakt mit der Oberseite des Substrats gebracht werden und auf diese Weise durch Adhäsion an der Oberseite des Substrats haften bleiben. Die Haftkraft zwischen den Bondmaterial-Ablagerungen und der Oberseite des Substrats ist dabei größer als die Haftkraft, mit der die Ablagerungen an den Kontaktierungsnadelenden anhaften. Die Adhäsion ist bekanntlich ein physikalischer Vorgang, bei dem zwei Elemente (hier die metallischen Partikel einerseits und das insbesondere langkettige Moleküle aufweisende polymere Substrat andererseits) auf Grund elektrostatischer Anziehung aneinander haften. Dazu weist das Substrat bzw. zumindest dessen Oberseite um- bzw. ausrichtbare Dipole auf, die für die erforderliche Anziehungskraft sorgen. Die Dipole richten sich entweder auf Grund des elektrischen Feldes der (geladenen) Partikel oder durch Ladungsträgerdiffusion (z. B. bei unpolaren (Metalloberflächen der) Partikel) durch die Grenzschicht zwischen Partikel und Substrat so aus oder aber werden durch eine entsprechende Vorbehandlung (z. B. durch Reiben - triboelektrisch) so ausgerichtet, dass ihre der Ladung der Partikel entgegengesetzten Pole den Partikeln zugewandt sind.

Die Entfernung der Ablagerungspartikel an den Kontaktierungsnadelenden durch Berührung mit der Oberseite des Substrats ist wesentlich schonender für die Enden der Kontaktierungsnadeln als die im Stand der Technik bekannte Entfernung der Ablagerungen durch ein abrasives Material, an dem die Enden der Kontaktierungsnadeln entlangbewegt werden. Damit verlängert sich die Einsatzdauer der Kontaktierungsnadeln. Überdies können, da die Kontaktierungsnadeln nicht abnutzen, die Reinigungs- bzw. Entfernungsvorgänge, das heißt das Kontaktieren des Substrats durch die Kontaktierungsnadeln öfter als die bisher im Stand der Technik bekannten Reinigungsvorgänge durchgeführt werden. Dies wiederum wirkt sich vorteilhaft auf die Kontaktierung der Kontaktierungsnadeln an den Bondpads der Dies aus, da sich durch die höhere Frequenz an Reinigungsvorgängen weniger Ablagerungspartikel an den Enden der Kontaktierungsnadeln ansammeln können, wodurch die Bondpads der zu testenden Dies geschont werden.

Grundsätzlich spielt die Härte des Materials an der Oberseite des Substrats keine Rolle für den Reinigungsvorgang, solange die Haft- und Adhäsionskraftverhältnisse so, wie oben angegeben, sind. Allerdings hat sich durch Versuche herausgestellt, dass es von Vorteil ist, wenn die Oberseite des Substrats nachgiebig ausgebildet ist und insbesondere elastisch ist. Beim Aufsetzen der Kontaktierungsnadelenden auf die elastische Oberseite des Substrats verformt sich dieses also örtlich durch Bildung einer trichterartigen Vertiefung, ohne dass die Enden der Kontaktierungsnadeln die Oberseite des Substrats durchdringen. Die Kontaktierungsnadelenden berühren also die Oberseite des Substrats in einem größeren (Flächen-)Bereich, so dass mehr Ablagerungspartikel durch Adhäsion an der Oberseite des Substrats haften bleiben. Für das Substrat bieten sich Materialien mit Rückfederungseigenschaften an, wie es beispielsweise bei Elastomer-Materialien der Fall ist. Besonders zweckmäßig ist es, wenn die Oberseite des Substrats ein künstliches oder natürliches Kautschuk-Material aufweist.

Besonders gute Testergebnisse wurden erzielt, wenn ein auf Polysiloxan basierendes Material an der Oberseite des Substrats oder ein Substrat aus diesem Material eingesetzt wird. Als bevorzugtes Material hat sich hier der unter dem Label _{"}GEL-PAK" von GEL Elastomere Technology und Vichem Corporation, Sunnyvale vertriebene Film mit der Bezeichnung PF-40/17-X8 herausgestellt. Dieses Material wird in der Halbleiter-Technologie z. B. beim einseitigen Abtragen von Siliziumscheiben eingesetzt, wenn es darum geht, deren Dicke zu verringern. Der Film wird dabei auf der unbehandelten Unterseite der Siliziumscheibe aufgebracht, um Beschädigungen beim Polieren der Oberseite der Siliziumscheibe zu verhindern. Ferner wird der oben genannte Film für den Transport von Dies eingesetzt.

Überraschenderweise hat sich bei Anwendung der erfindungsgemäßen Lehre herausgestellt, dass es gelingt, einzig und allein durch eine geeignete Wahl von Materialpaarungen der Substratoberseite und den Partikelablagerungen diese durch elektrostatische Adhäsion von den Enden der Kontaktierungsnadeln abzulösen. Dieser Vorgang ist extrem schonend für die Kontaktierungsnadelenden, was deren Lebensdauer verlängert. Insbesondere verbleiben keinerlei Rückstände des Substrats (Reinigungsmaterial) an den Kontaktierungsnadeln, da diese nicht in das Substrat eindringen sondern lediglich, eventuell unter Eindrückung der Oberseite des Substrats, in Kontakt mit dem Substrat gebracht werden.

Das Substrat kann entweder durch und durch aus dem Material seiner Oberseite bestehen, oder aber an seiner Oberseite eine Beschichtung aus einem Material aufweisen, das zu den oben erwähnten auf (elektrostatische) Adhäsionsprozesse zurückzuführenden Ergebnissen führt. Die Haftkraft zwischen diesem Beschichtungsmaterial und dem Substrat sollte dabei größer sein als zwischen dem Beschichtungsmaterial und den Ablagerungspartikeln, da ansonsten die Gefahr besteht, dass sich das Beschichtungsmaterial beim Wegbewegen der Kontaktierungsnadelenden nach einer Kontaktierung des Beschichtungsmaterials vom Substrat ablöst.

Das erfindungsgemäße Konzept wird nachfolgend unter Bezugnahme auf die Zeichnung erläutert. Im einzelnen zeigen:
- Fig. 1: in Seitenansicht das Ende einer Kontaktierungsnadel mit an dieser haftenden Bondpadmaterialpartikeln oberhalb eines Adhäsions-Reinigungssubstrats vor dessen Kontaktierung, wobei von dem Substrat lediglich die obere Grenzschicht zur Nadel dargestellt ist,
- Fig. 2: die Kontaktierungsnadel in demjenigen Zustand, in dem ihr Ende die Oberseite des Substrats unter lokaler Verformung desselben berührt und
- Fig. 3: die oberhalb des Substrats angeordnete Kontaktierungsnadel nach deren Wegbewegung vom Substrat.

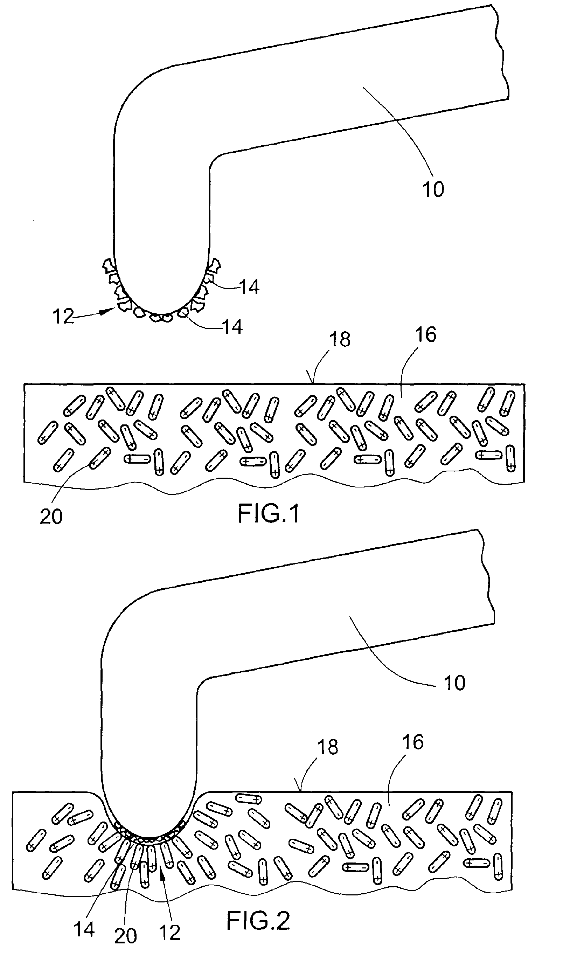

In Fig. 1 ist in Seitenansicht eine Kontaktierungsnadel 10 dargestellt, an deren in diesem Fall runden Ende 12 Partikel 14 aus Bondpadmaterial haften. Das Ende 12 der Kontaktierungsnadel 10 befindet sich oberhalb eines Substrats 16, das eine Oberseite 18 aufweist. Das Substrat 16 besteht aus einem auf Polysiloxan basierenden Material, bei dem es sich insbesondere um das unter dem Label _{"}GEL-PAK" von Vichem Corporation, Sunnyvale unter der Bezeichnung PF-40/17-X8 vertriebenen Material handelt. Dieses Material weist um- bzw. ausrichtbare Dipole 20 auf.

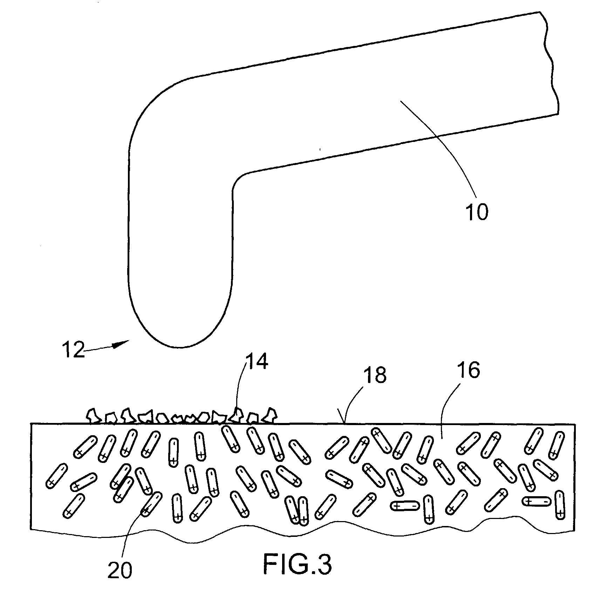

Der Reinigungsprozess des Endes 12 der Kontaktierungsnadel 10 erfolgt dadurch, dass dieses Ende 12 die Oberseite 18 des Substrats 16 kontaktiert, wobei die Partikel 14 auf Grund (elektrostatischer) Adhäsion auf der Oberseite 18 haften bleiben. Die Partikel 14 sind im wesentlichen unipolar. Auf Grund der von-der-Waals-Wechselwirkungen und Ladungsträgerdiffusionen werden sich die Dipole 20 des Substrats 16, die sich in unmittelbarer Nähe desjenigen Bereichs der Oberfläche 18 befinden, in dem das Substrat 16 von dem Ende 12 der Kontaktierungsnadel 10 berührt wird, ausrichten. Mit Hilfe von thermodynamischen Überlegungen lässt sich berechnen, dass sich in der Grenzfläche starke chemische Potentiale aufbauen. Durch solche Grenzflächen-Kontakte steigt die freie Energie des Mehrphasen-Systems. Unter der Wirkung dieser Potentiale beginnt eine Wanderung von Elektronen durch die Grenzfläche von einer Phase in die andere. Diese Wanderung hält so lange an, bis das chemische Potential an der Phasen-Grenzfläche energetisch ausgeglichen ist. Dadurch bildet sich aber nicht etwa ein spannungsfreies Gleichgewicht, sondern im Gegenteil eine elektrische Doppelschicht aus. Diese Situation ist in Fign. 2 und 3 dargestellt, die wie die übrigen Figuren den oberen Grenzschichtbereich des Substrats zeigen, wobei in Fig. 2 zusätzlich zu erkennen ist, dass sich das Substrat 16 an der Kontaktierungsstelle mit dem Ende 12 der Kontaktierungsnadel 10 einwärts wölbt.

Wenn ausgehend von der Situation gemäß Fig. 2 die Kontaktierungsnadel 10 nun wiederum von der Oberseite 18 des Substrats 16 wegbewegt wird, so verbleiben die Partikel 14 auf Grund der elektrostatischen Anziehungskräfte (Adhäsion) auf der Oberseite 18 des Substrats 16. Mit anderen Worten sind also die elektrostatischen Adhäsionskräfte zwischen der Oberseite 18 des Substrats 16 und den Partikeln 14 größer als die Kraft, mit der die Partikel 14 an dem Ende 12 der Kontaktierungsnadel 10 haften.

## Patentansprüche

1. Vorrichtung zum Entfernen von an den Enden von Kontaktierungsnadeln zum Kontaktieren der Bondpads eines Dies haftenden Bondpadmaterial-Ablagerungen, mit
- einem Substrat mit einer adhäsiven Oberseite, die von den Enden der Kontaktierungsnadeln kontaktierbar ist und die derart beschaffen ist, dass die Haftkraft zwischen den Ablagerungen und der Oberfläche des Substrats größer ist als die Haftkraft zwischen den Ablagerungen und den Enden der Kontaktierungsnadeln.

2. Vorrichtung nach Anspruch 1, dadurch gekennzeichnet, dass die Oberseite des Substrats nachgiebig, insbesondere elastisch ist.

3. Vorrichtung nach Anspruch 1 oder 2, dadurch gekennzeichnet, dass die Oberseite des Substrats ein Polymer- und/oder Elastomer-Material aufweist.

4. Vorrichtung nach einem der Ansprüche 1 bis 3, dadurch gekennzeichnet, dass die Oberseite des Substrats Kautschuk aufweist.

5. Vorrichtung nach einem der Ansprüche 1 bis 4, dadurch gekennzeichnet, dass die Oberseite des Substrats ein auf Polysiloxan basierendes Material aufweist.

6. Vorrichtung nach einem der Ansprüche 1 bis 5, dadurch gekennzeichnet, dass die Oberseite des Substrats von einer Oberseiten-Beschichtung gebildet ist und dass die Haftung der Beschichtung zum Substrat größer ist als die Haftung der Ablagerungen der Enden der Kontaktierungsnadeln an der Beschichtung.

7. Verfahren zum Entfernen von an den Enden von Kontaktierungsnadeln zum Kontaktieren der Bondpads eines Dies haftenden Bondpadmaterial-Ablagerungen, bei dem
- die die Ablagerungen aufweisenden Enden der Kontaktierungsnadeln in Kontakt mit der eine Haftkraft auf die Ablagerungen ausübenden Oberseite eines Substrats gebracht werden, deren Haftkraft größer ist als die Haftkraft zwischen den Ablagerungen und den Enden der Kontaktierungsnadeln.

8. Verwendung eines eine Haftkraft erzeugenden Oberseite aufweisenden Substrats zum Entfernen von mit einer niedrigen Haftkraft an den Enden von Kontaktierungsnadeln zum Kontaktieren der Bondpads von Halbleiterdies haftenden Ablagerungen durch Berührung der Oberseite des Substrats mit den Enden der Kontaktierungsnadeln.

9. Verfahren nach Anspruch 7 oder Verwendung nach Anspruch 8, mit dem Substrat einer Vorrichtung nach einem der Ansprüche 1 bis 7.
